# EUROPEAN PATENT SPECIFICATION

(11) **EP 1 148 389 B1**
(45) Date of publication and mention of the grant of the patent: **27.02.2008**
(21) Application number: 01303479.8
(22) Date of filing: 12.04.2001
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 17.04.2000 EP 00201355
(43) Date of publication of application: 24.10.2001
(73) Proprietor: ASML Netherlands B.V., 5504 DR Veldhoven (NL)
(72) Inventor: Janssen, Hendricus Wilhelmus Aloysius, 5653 PR Eindhoven (NL); Renkens, Michael Jozefa Mathijs, 6162 JG Geleen (NL); Tabor, Rob, 5704 HA Helmond (NL); Vijfvinkel, Jakob, 5652 LH Eindhoven (NL); Schneider, Ronald Maarten, 5665 Geldrop (NL); Bisschops, Theodorus Hubertus Josephus, 5616 GG Eindhoven (NL)
(74) Representative: Leeming, John Gerard

(56) References cited:
- EP-A- 0 244 012
- EP-A- 0 964 281
- EP-A- 0 973 067
- US-A- 4 615 515
- US-A- 5 218 896
- US-A- 5 806 193

## Description

The present invention relates to a lithographic projection apparatus comprising:
- a radiation system for supplying a projection beam of radiation;
- a mask table for holding a mask, the mask serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. The required matrix addressing can be performed using suitable electronic means. More information on such mirror arrays can be gleaned, for example, from United States Patents US 5,296,891 and US 5,523,193.
- A programmable LCD array. An example of such a construction is given in United States Patent US 5,229,872.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example in US 5,969,441 and WO 98/40791.

In a lithographic apparatus, the size of features that can be imaged onto the wafer is limited by the wavelength of the projection radiation. To produce integrated circuits with a higher density of devices and hence higher operating speeds, it is desirable to be able to image smaller features. Whilst most current lithographic projection apparatus employ ultraviolet light generated by mercury lamps or excimer lasers, it has been proposed to use shorter wavelength radiation of around 13 nm. Such radiation is termed extreme ultraviolet (EUV) or soft x-ray, and possible sources include laser-produced plasma sources, discharge sources or synchrotron radiation from electron storage rings. An outline design of a lithographic projection apparatus using synchrotron radiation is described in "Synchrotron radiation sources and condensers for projection x-ray lithography", JB Murphy et al, Applied Optics Vol. 32 No. 24 pp 6920-6929 (1993).

Other proposed radiation types include electron beams and ion beams. These types of beam share with EUV the requirement that the beam path, including the mask, substrate and optical components, be kept in a high vacuum. This is to prevent absorption and/or scattering of the beam, whereby a total pressure of less than about 10⁻⁶ millibar is typically necessary for such charged particle beams. Wafers can be contaminated, and optical elements for EUV radiation can be spoiled, by the deposition of carbon layers on their surface, which imposes the additional requirement that hydrocarbon partial pressures should generally be kept below 10⁻⁸ or 10⁻⁹ millibar. Otherwise, for apparatus using EUV radiation, the total vacuum pressure need only be 10⁻³ or 10⁻⁴ mbar, which would typically be considered a rough vacuum. Further information with regard to the use of electron beams in lithography can be gleaned, for example, from US 5,079,122 and US 5,260,151, as well as from EP-A-0 965 888.

Working in such a high vacuum imposes quite onerous conditions on the components that must be put into the vacuum and on the vacuum chamber seals, especially those around any part of the apparatus where a motion must be fed-through to components inside the chamber from the exterior. For components inside the chamber, materials that minimise or eliminate contaminant and total outgassing, i.e. both outgassing from the materials themselves and from gases adsorbed on their surfaces, should be used.

For certain applications, a gravity compensator is required to exert a bias force that at least partially counteracts the weight of an object to be supported and which compensator largely prevents transmission of vibrations in the support direction. The height of the object may be varied by motors, and the application of a gravity compensator relieves the motors of supplying a force to overcome gravity, leading to a considerable reduction in power consumption and heating of the motors. However, such gravity compensators having a pneumatic working principle are known, but their application in a vacuum environment is presently not feasible, since the possibly evolving gas out of the gravity compensator would seriously disturb the vacuum. To prevent transmission of vibrations in a horizontal direction, it is known to provide a supporting means, such as a pneumatic gravity compensator, with a horizontal air bearing. Gas flowing out of the horizontal gas bearing will seriously disturb the vacuum. Above supporting means are described in EP 0 973 067.

EP-A-0-244-012 describes a positioning device for use in a lithographic apparatus in which two supports are inter-connected by a parallelogram mechanism of elastically deformable rods.

An object of the present invention is to provide a supporting means that does not require a gas bearing and gas supply to prevent transmission of vibrations in the horizontal direction. Another object of the present invention is to provide a supporting means for use in a lithographic projection apparatus, which accommodates displacements in the horizontal plane of a supported object, thereby largely preventing transmission of vibrations to the object and which can be employed in a vacuum chamber.

According to the present invention, these and other objects are achieved in a lithographic projection apparatus as defined in the appended claims.

According to yet a further aspect of the invention there is provided a method for manufacturing a device as defined in the appended claims.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e*.*g*. with a wavelength of 365, 248, 193, 157 or 126 nm) and EUV (extreme ultra-violet radiation, *e*.*g*. having a wavelength in the range 5-20 nm), as well as particle beams, such as ion beams or electron beams.

The invention and its attendant advantages will be further elucidated with the aid of an exemplary Embodiment and the accompanying schematic drawings, in which:
Figure 1 depicts a lithographic projection apparatus according to an embodiment of the invention;
Figure 2 depicts part of short-stroke positioning means according to the invention;
Figure 3 depicts a detail of evacuating means according to the invention;
Figure 4a depicts a schematic representation of a mass on a hingedly connected rigid rod; and
Figure 4b depicts a schematic representation of a mass on a rigidly connected flexible rod.
Figure 5 depicts part of short-stroke positioning means described for reference.
Figure 6 depicts a schematic representation of a supporting means according to an embodiment of the invention.
Corresponding features in the various figures are denoted by the same reference symbols.

### Embodiment 1

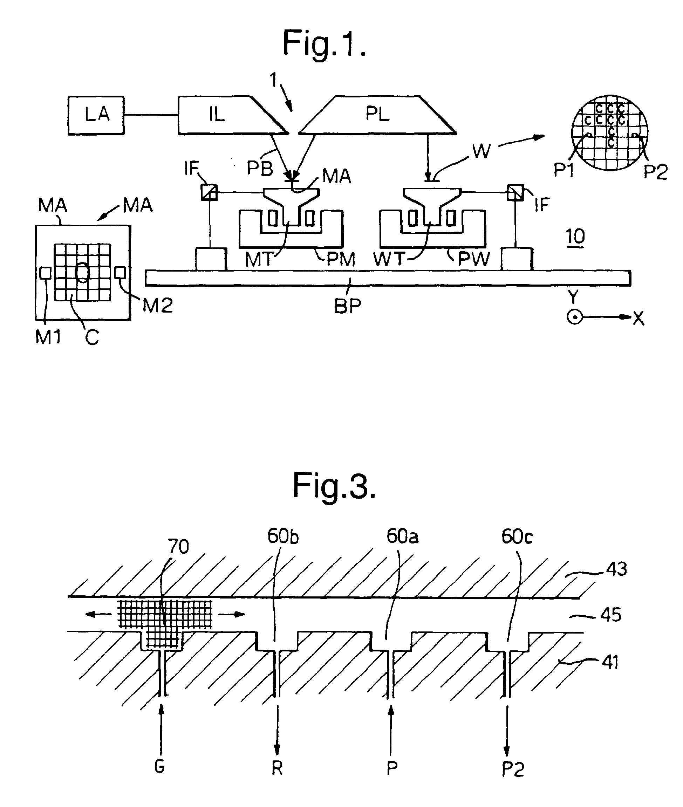

Figure 1 schematically depicts a lithographic projection apparatus according to a particular embodiment of the invention. The apparatus comprises:
a radiation system Ex, IL, for supplying a projection beam PB of radiation (*e.g.* UV or EUV radiation, electrons or ions). In this particular case, the radiation system also comprises a radiation source LA;
a first object table (mask table) MT provided with a mask holder for holding a mask MA (*e*.*g*. a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e*.*g*. a refractive or catadioptric system, a mirror group or an array of field deflectors) for imaging an irradiated portion of the mask MA onto a target portion C (*e*.*g*. comprising one or more dies) of the substrate W.

As here depicted, the apparatus is of a reflective type (*i*.*e*. has a reflective mask). However, in general, it may also be of a refractive type, for example (with a transmissive mask). Alternatively, the apparatus may employ another kind of patterning means, such as a programmable mirror array of a type as referred to above.

The source LA (*e*.*g*. an excimer laser, an undulator or wiggler provided around the path of an electron beam in a storage ring or synchrotron, a laser-produced plasma source, a discharge source or an electron or ion beam source) produces a beam of radiation. This beam is fed into an illumination system (illuminator) IL, either directly or after having traversed conditioning means, such as a beam expander, for example. The illuminator may comprise adjusting means for setting the outer and/or inner radial extent (commonly referred to as σ-outer and σ-inner, respectively) of the intensity distribution in the beam. In addition, it will generally comprise various other components, such as an integrator and a condenser. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short-stroke actuator, or may be fixed.

The depicted apparatus can be used in two different modes:
1. In step mode, the mask table MT is kept essentially stationary, and an entire mask image is projected in one go (*i*.*e*. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.
The embodiment shown employs a projection beam of EUV radiation and is therefore provided with a vacuum environment, or chamber, 10 since most gases tend to absorb the EUV radiation.

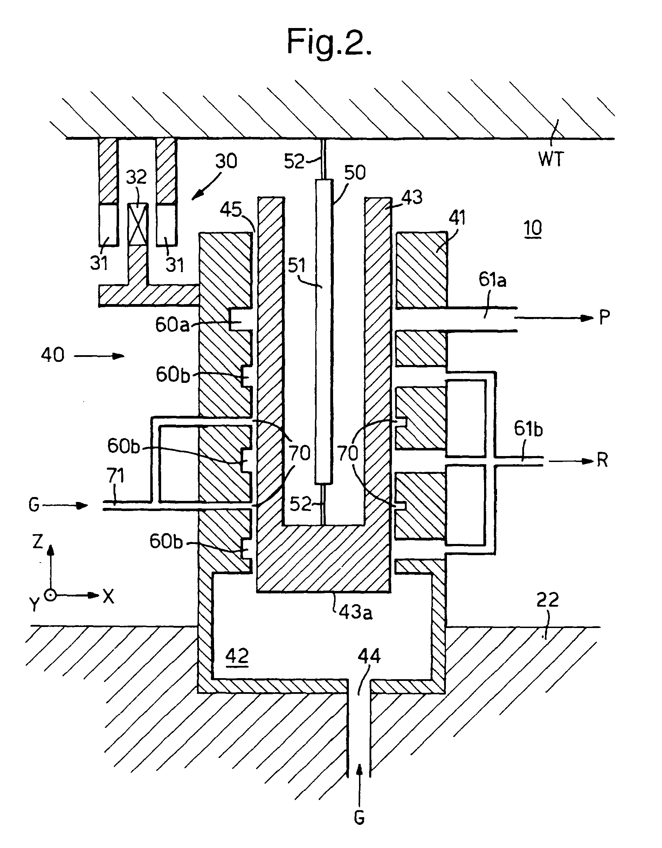

Figure 2 shows a part of the short-stroke positioning means connected to the substrate table WT, which positioning means is employed for fine positioning of the substrate W (not shown in figure 2) with respect to the projection system PL. The lower part, or foot, 22 of the shown configuration is connected to the long-stroke positioning means (not shown) for course positioning of the substrate table WT with respect to the projection system PL. This foot 22 is able to move over base plate BP (shown in figure 1). The configuration as shown in figure 2 is mounted in vacuum chamber 10.

Substrate table WT may be changed in height with respect to lower part 22 with the aid of short-stroke motors taking the form of so-called Lorentz-force motors. One Lorentz-force motor 30 for changing the height is schematically depicted in figure 2 and comprises a system of permanent magnets 31 mounted such as to have an identical magnetic orientation and a system of electric conductors 32 that may carry an electrical current for generating a Lorentz force in the vertical Z-direction to vary the distance in between substrate table WT and lower part 22. In general, more than one Lorentz-force motor for the vertical direction is provided. The system of magnets 31 is secured to substrate table WT and the system of electrical conductors 32 is secured to lower part 22. Further Lorentz-force motors (not shown) are present to horizontally displace, tilt and rotate substrate table WT with respect to lower part 22. Dimensions of the Lorentz-force motors are chosen such that a displacement induced by one Lorentz-force motor is not obstructed by the other Lorentz-force motors over a selected short-stroke range of displacement.

A supporting means, or gravity compensator, 40 is provided to at least substantially support substrate table WT against gravity with respect to lower part 22. Lorentz-force motor 30 is therefore relieved of generating such a supporting force, which would lead to a high energy dissipation in conductors 32. In general, more than one gravity compensator will be provided.

Gravity compensator 40 comprises a cylindrical housing 41 provided with a pressure chamber 42, and a piston 43 which is journaled relative to said housing in the vertical, or support, direction. Housing 41 is secured to lower part 22 and piston 43 is through a rod 50 connected to substrate table WT. Pressure chamber 42 is in fluid communication with gas supply means G (not shown) via a channel 44 to provide a gas having a predetermined pressure in the pressure chamber. In this manner a pneumatic supporting force is generated to vertically support piston 43 in housing 41 by the gas pressure present in pressure chamber 42 and acting on bottom surface 43a of piston 43. The gas supply means regulates the pressure in pressure chamber 42 such that the pneumatic supporting force will support substrate table WT against gravity. The supporting force is essentially constant, irrespective of the position of piston 43 in the vertical Z-direction.

For further details on long-stroke and short-stroke positioning means and on gravity compensators, one is referred to European patent application EP 0 973 067.

Gas may escape from pressure chamber 42 via the gap 45 in between piston 43 and the inner wall of cylindrical housing 41 and enter vacuum chamber 10, which would substantially disturb the vacuum within the vacuum chamber. The inner wall of housing 41 acts as a bearing surface for piston 43. To prevent gas from escaping to vacuum chamber 10, gravity compensator 40 is provided with evacuating grooves 60a, 60b in its inner wall surrounding piston 43. Grooves 60a, 60b are via conduits 61a, 61b connected to a vacuum pump P (not shown) and a reservoir R (not shown), respectively, to draw gas from the grooves and gap 45. Gas escaping through gap 45 in between housing 41 and piston 43 will thus substantially escape via grooves 60a, 60b to reservoir R and vacuum pump P, and not towards vacuum chamber 10. Vacuum groove 60a will be set to a lower pressure than grooves 60b. Depending on the required vacuum level of chamber 10, more vacuum grooves may be provided, each groove in a direction towards the vacuum chamber being evacuated to a lower pressure level, *i*.*e*. a higher vacuum level.

As shown in figure 2, two gas bearings 70 are provided in between the inner wall of housing 41 and piston 43. The gas bearings provide for a friction-less displacement of piston 43 within housing 41, so as to prevent a transmission of vibrations from lower part 22 to substrate table WT in the vertical direction. Gas at a pressure of a few bars is introduced from a gas supply G via conduits 71 to gap 45 to establish the gas bearings 70. Grooves 60b are provided aside the gas bearings to evacuate gas introduced from gap 45, so as to prevent the escape of gas to vacuum chamber 10 and to provide for stable gas bearings 70. In the embodiment shown, the gas bearings are set to an identical pressure. However, the pressure may be set to different pressures by separated conduits 71 in a further embodiment. Further, more than two or just one gas bearing may be provided.

Figure 3 shows a detail of air bearing 70 and evacuating grooves 60a, 60b. Air bearing 70 may be set to a pressure of 6 bar and grooves 60b allow gas to escape to a reservoir R at atmospheric pressure. Vacuum groove 60a is connected to a vacuum pump P (not shown) that allows evacuating to a pressure level of 1.5 mbar. Gaps having a length of 5-10 mm and a width of 2-25 µm in between gas bearing 70 and groove 60b, groove 60b and groove 60a, and groove 60a and vacuum chamber allow a vacuum of 5×10⁻⁷ mbar to be reached within vacuum chamber 10. Figure 3 also shows a further vacuum groove 60c connected to a further vacuum pump P2 to allow an even higher vacuum to be reached in vacuum chamber 10.

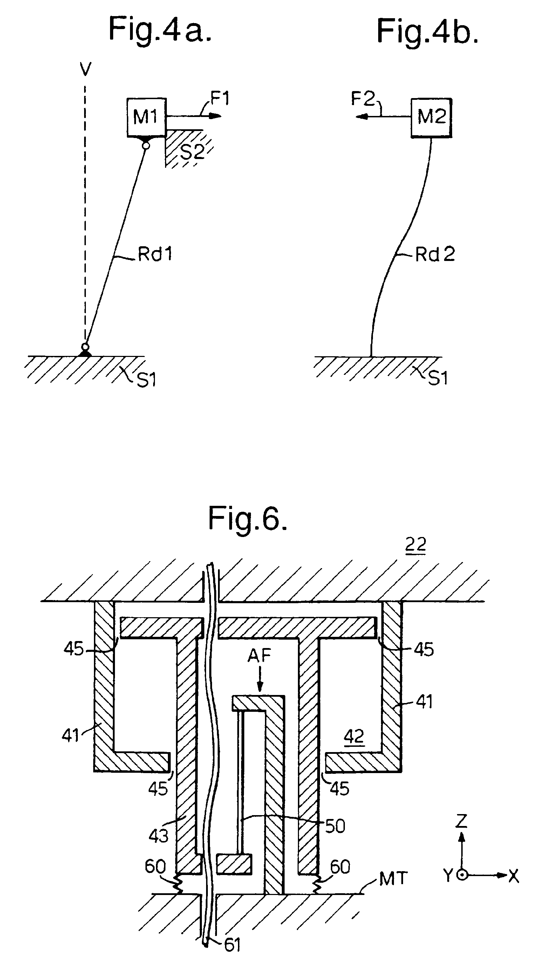

Rod 50 connects piston 43 to substrate table WT and allows for displacement of upper part in a horizontal XY-plane, i.e. perpendicular to the support direction. The configuration of rod 50 is chosen such that it stably supports substrate table WT, but also allows displacement in the horizontal plane with negligible or no force exerted on the substrate table in the horizontal direction. A transmission of vibrations to the substrate table in the horizontal plane is therefore largely prevented. Figures 4a and 4b further demonstrate above requirements for rod 50.

A mass M1 supported by a rigid rod Rd1 that is hingedly connected to mass M1 and supporting surface S1 will, due to gravity acting along the vertical support direction, exert a force F1 in the horizontal plane on some support S2 when mass M1 is not exactly positioned above the connection of rod Rd1 to supporting surface S1, *i*.*e*. when M1 is displaced with respect to the vertical V, its gravitational equilibrium state. Such a situation is shown in figure 4a. A flexible rod Rd2 that is rigidly secured to both mass M2 and supporting surface S 1 will exert a force F2 in the horizontal plane on mass M2 when the latter is displaced from the vertical V and the bottom surface of mass M2 is kept parallel to supporting surface S1, as is shown in figure 4b, such that a bending moment is exerted on flexible rod Rd2. However, mass M2 will also exert a force F1 on rod Rd2 as is explained with reference to figure 4a, force F1 being opposed to force F2. The configuration of rod Rd2 may be chosen such that forces F1 and F2 will at least substantially cancel each other. Mass M2 will then stably balance on rod Rd2 and may be displaced in the horizontal XY-plane around vertical V without a substantial force being exerted on mass M2. The gravity force acting parallel to the support direction thus provides a so called "negative stiffness" to rod 50.

Rod 50 in figure 2 is configured, i.e. has stiffness in a direction perpendicular to the support direction, such that the situation as explained with reference to figure 4b is applicable. The rod may be made of a solid material having a uniform stiffness throughout its length, but the rod may also comprise (as shown in figure 2) a rigid intermediate part 51 and two flexible parts 52. One flexible part is rigidly secured to piston 43 and the other flexible part is rigidly secured to substrate table WT. The elasticity, length and cross-sectional shape of the flexible parts have to be chosen so as to comply with a selected length of rod 50 and the mass of substrate table WT, such that the situation as explained with regard to figure 4b holds.

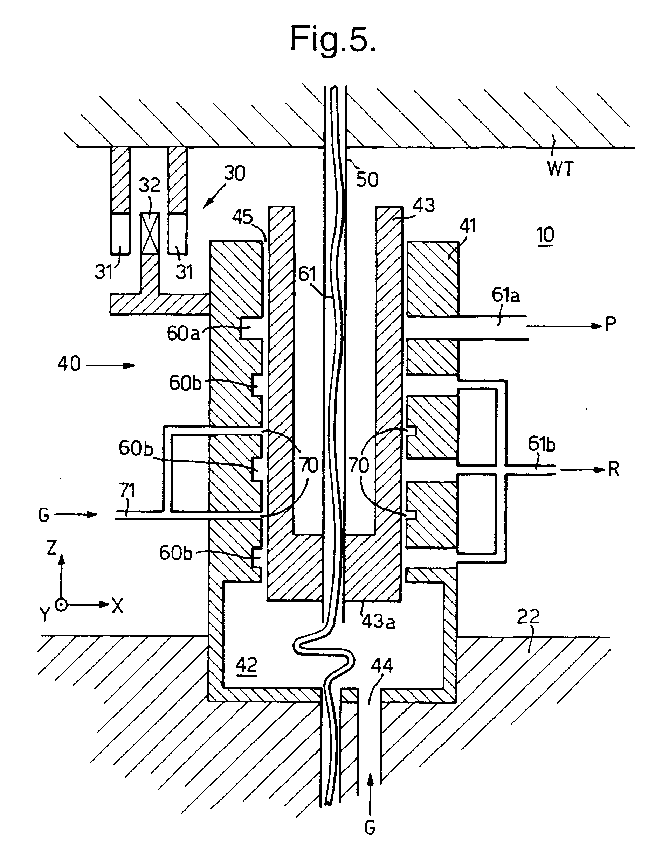

Figure 5 shows schematically a supporting means 40 in which rod 50 is provided with a hollow part. Through the hollow part a conduit may be fed, through which, for example, a liquid (e.g. cooling water) or an electrical or signal connection is provided to the substrate table WT. Conduits are generally made of materials that tend to release undesirable contaminants in a vacuum environment. The proposed arrangement prevents such contamination.

Figure 6 depicts schematically a means 40 according to a second embodiment of the invention. In the second embodiment a supported mask table MT is provided below a supporting upper part 22 that is connected to long-stroke positioning means. The various parts as described for the first embodiment can also be distinguished in figure 6. The figure further shows that conduits 61 are provided separate from rod 50. A bellows 60 is provided through which conduits 61 is passed to mask table MT. Both bellows 60 and conduits 61 provide an additional stiffness in the horizontal direction. To compensate for such an extra stiffness and, moreover, to generally provide for an adjustable negative stiffness, there is provided a means to generate an adjustable force AF along the support direction. Force AF may be accomplished by addition of an (extra) mass on the mask table MT, by using an (adjustable) spring or by applying air pressure, for example.

Whilst specific embodiments of the invention are disclosed above, it will be appreciated that the invention may be practiced other than described. The description is not intended to limit the invention. For instance, the invention has been described with reference to a wafer or substrate table, but is also applicable to a mask table or vice versa.

## Claims

1. A lithographic projection apparatus comprising:
- a radiation system (IL) for providing a projection beam of radiation;
- a mask table (MT) for holding a mask (MA), the mask (MA) serving to pattern the projection beam according to a desired pattern;
- a substrate table (WT) for holding a substrate;
- a projection system (PL) for projecting the patterned beam onto a target portion of the substrate; and
- a supporting means (40) for supporting the mask table (MT) or the substrate table (WT), the supporting means (40) comprising a support member (50) having a finite stiffness in a perpendicular direction that is substantially perpendicular to a support direction of the support member; and
a vacuum chamber (10) having a wall enclosing the supporting means, the supporting means further comprising:
a gas-filled pressure chamber (42), the gas in the pressure chamber acting on a movable member (43) such as to at least partially counteract a force substantially parallel to the support direction, and
evacuating means (60a,60b,61a,61b) constructed and arranged so as to evacuate gas escaping towards the vacuum chamber through a gap (45) between the movable member (43) and a bearing surface (41); wherein
the stiffness of the support member (50) is such that a deformation force in the perpendicular direction by the support member due to a deformation of the support member in the perpendicular direction substantially counteracts an opposite displacing force in the perpendicular direction due to a force substantially parallel to the support direction acting on the support member to allow displacement of the mask table (MT) or the substrate table (WT) in the perpendicular direction with negligible or no force exerted on the mask table (MT) or substrate table (WT) in the perpendicular direction.

2. An apparatus according to claim 1, wherein the support member comprises a rod (50).

3. An apparatus according to claim 2, wherein the rod (50) comprises a rigid part (51) and a flexible part (52).

4. An apparatus according to any one of the preceding claims, wherein a means (30) for applying an additional force on the support member along the support direction is provided.

5. An apparatus according to any one of the preceding claims, wherein the support member (50) is connected to the moveable member (43).

6. An apparatus according to any one of the preceding claims, wherein the supporting means (40) further comprises a bearing (70,71) for bearing the movable member (43) and maintaining the gap (45) between the movable member and the bearing surface (41), the bearing comprises a gas bearing for providing pressurized gas into the gap thereby generating forces tending to hold the movable member away from the bearing surface, and the evacuating means (60a,60b,61a,61b) being provided between the gas bearing and the vacuum chamber along the movable member so as to remove gas from the gap.

7. An apparatus according to claim 6, wherein the gas bearing comprises an elongate groove (70) in one surface defining the gap; and gas supply means (71) for supplying gas under pressure to said elongate groove.

8. An apparatus according to any one of the preceding claims, wherein the evacuating means comprises a conduit means (61b) providing a fluid communication between the gap and at least one reservoir (R) at a pressure higher than that of the vacuum chamber and lower than that of the gas to be removed from the gap.

9. An apparatus according to claim 8, wherein the conduit means comprises at least one elongate groove (60a,60b) in a surface defining the gap.

10. An apparatus according to any one of the preceding claims, wherein the evacuating means comprises further conduit means (61a) providing a fluid communication between the gap and a least one vacuum pump.

11. An apparatus according to claim 10, wherein the further conduit means comprises at least one elongate vacuum groove (60c) in a surface defining the gap.

12. An apparatus according to claim 11, wherein the further conduit means comprises more than one elongate vacuum grove (60a,60c) in a surface defining the gap, the vacuum grooves in general being parallel and the respective grooves towards the vacuum chamber being drawn to a deeper vacuum by the vacuum pump(s).

13. An apparatus according to any one of the preceding claims wherein the movable member comprises a piston (43) being journaled in a housing (41) provided with the gas-filled pressure chamber, an inner wall of the housing providing the bearing surface.

14. An apparatus according to any one of the preceding claims, wherein the radiation system comprises a radiation source (LA).

15. A method for manufacturing a device using a lithographic projection apparatus according to any of the preceding claims, the method comprising the steps of:
- providing a substrate that is at least partially covered by a layer of radiation-sensitive material;
- using a mask (MA) to endow the projection beam with a pattern in its cross-section;
- projecting the patterned beam of radiation onto a target portion of the layer of the radiation-sensitive material,
- providing an isolated reference frame; and
- supporting one of the mask table (MT) and the substrate table (WT) with a support means comprising a support member having a finite stiffness in a perpendicular direction that is substantially perpendicular to a support direction of the support member.

## Patentansprüche

1. Ein lithographischer Projektionsapparat, aufweisend:
ein Strahlungssystem (IL) zur Bereitstellung eines Projektionsstrahls einer Strahlung;
einen Maskentisch (MT) zum Halten einer Maske (MA), wobei die Maske (MA) dazu dient, den Projektionsstrahl gemäß einem gewünschten Muster zu mustern;
einen Substrattisch (WT) zum Halten eines Substrats;
ein Projektionssystem (PL) zum Projizieren des gemusterten Strahls auf einen Zielabschnitt des Substrats; und
Tragmittel (40) zum Tragen des Maskentischs (MT) oder des Substrattischs (WT), wobei die Tragmittel (40) ein Tragteil (50) aufweisen, das eine begrenzte Steifigkeit in einer senkrechten Richtung hat, die im Wesentlichen senkrecht zu einer Tragrichtung des Tragteils ist; und
eine Vakuumkammer (10) mit einer Wand, welche die Tragmittel einschließt, wobei die Tragmittel weiterhin aufweisen:
eine gasgefüllte Druckkammer (42), wobei das Gas in der Druckkammer auf ein bewegliches Bauteil (43) derart wirkt, dass einer Kraft im Wesentlichen parallel zur Tragrichtung zumindest teilweise entgegengewirkt wird; und
Evakuiermittel (60a, 60b, 61a, 61b), die so aufgebaut und angeordnet sind, dass sie Gas abführen, das in Richtung der Vakuumkammer durch einen Spalt (45) zwischen dem beweglichen Bauteil (43) und einer Lagerfläche (41) austritt, wobei
die Steifigkeit des Tragteils (50) derart ist, dass eine Verformungskraft in einer senkrechten Richtung durch das Tragteil aufgrund einer Verformung des Tragteils in der senkrechten Richtung einer entgegen gesetzten Verschiebungskraft in der senkrechten Richtung aufgrund einer Kraft im Wesentlichen parallel zur Tragrichtung, die auf das Tragteil wirkt, im Wesentlichen entgegenwirkt, um eine Verschiebung des Maskentisches (MT) oder des Substrattisches (WT) in der senkrechten Richtung mit vernachlässigbarer oder keiner Kraft zu ermöglichen, die auf dem Maskentisch (MT) oder dem Substrattisch (WT) in der senkrechten Richtung ausgeübt wird.

2. Ein Apparat nach Anspruch 1, wobei das Tragteil einen Stab (50) aufweist.

3. Ein Apparat nach Anspruch 2, wobei der Stab (50) einen steifen Teil (51) und einen flexiblen Teil (52) aufweist.

4. Ein Apparat nach einem der vorher gehenden Ansprüche, wobei ein Mittel (30) vorgesehen ist, um eine zusätzliche Kraft auf das Tragteil entlang der Tragrichtung aufzubringen.

5. Ein Apparat nach einem der vorher gehenden Ansprüche, wobei das Tragteil (50) mit dem beweglichen Bauteil (43) verbunden ist.

6. Ein Apparat nach einem der vorher gehenden Ansprüche, wobei die Tragmittel (40) weiterhin ein Lager (70, 71) aufweisen, um das bewegliche Bauteil (43) zu lagern und um den Spalt (45) zwischen dem beweglichen Bauteil und der Lagerfläche (41) aufrecht zu erhalten, wobei das Lager ein Gaslager zur Bereitstellung von Druckgas in den Spalt aufweist, so dass Kräfte erzeugt werden, die dazu neigen, das bewegliche Bauteil entfernt von der Lagerfläche zu halten und wobei die Evakuiermittel (60a, 60b, 61a, 61b) zwischen dem Gaslager und der Vakuumkammer entlang des beweglichen Bauteils angeordnet sind, um Gas aus dem Spalt zu entfernen.

7. Ein Apparat nach Anspruch 6, wobei das Gaslager eine lang gestreckte Ausnehmung (70) in einer Oberfläche, die den Spalt definiert und Gaszuführmittel (71) aufweist, um Gas unter Druck der lang gestreckten Ausnehmung zuzuführen.

8. Ein Apparat nach einem der vorhergehenden Ansprüche, wobei die Evakuiermittel Leitungsmittel (61b) aufweisen, die eine Fluidverbindung zwischen dem Spalt und wenigstens einem Reservoir (R) mit einem Druck höher als demjenigen der Vakuumkammer und niedriger als demjenigen des Gases, das aus dem Spalt zu entfernen ist, aufweisen.

9. Ein Apparat nach Anspruch 8, wobei die Leitungsmittel wenigstens eine lang gestreckte Ausnehmung (60a, 60b) in einer Oberfläche, die den Spalt definiert, aufweisen.

10. Ein Apparat nach einem der vorher gehenden Ansprüche, wobei die Evakuiermittel weiterhin Leitungsmittel (61a) aufweisen, die eine Fluidverbindung zwischen dem Spalt und wenigstens einer Vakuumpumpe bilden.

11. Ein Apparat nach Anspruch 10, wobei die weiteren Leitungsmittel wenigstens eine lang gestreckte Vakuumausnehmung (60c) in einer den Spalt definierenden Oberfläche aufweisen.

12. Ein Apparat nach Anspruch 11, wobei die weiteren Leitungsmittel mehr als eine lang gestreckte Vakuumausnehmung (60a, 60c) in einer Oberfläche, die den Spalt definiert, aufweisen, wobei die Vakuumausnehmungen im Wesentlichen parallel sind und die jeweiligen Ausnehmungen in Richtung der Vakuumkammer durch eine Vakuumpumpe oder Vakuumpumpen auf ein tieferes Vakuum gezogen werden.

13. Ein Apparat nach einem der vorhergehenden Ansprüche, wobei das bewegliche Bauteil einen Kolben (43) aufweist, der in einem Gehäuse (41), das mit der gasgefüllten Druckkammer versehen ist, geführt ist, wobei eine Innenwand des Gehäuses die Lagerfläche liefert.

14. Ein Apparat nach einem der vorher gehenden Ansprüche, wobei das Strahlungssystem eine Strahlungsquelle (LA) aufweist.

15. Ein Verfahren zur Herstellung einer Vorrichtung unter Verwendung eines lithographischen Projektionsapparats nach einem der vorhergehenden Ansprüche, wobei das Verfahren die Schritte aufweist von:
Bereitstellen eines Substrats, das zumindest teilweise mit einer Schicht aus strahlungsempfindlichen Material bedeckt ist;
Verwendung einer Maske (MA), um den Projektionsstrahl in seinem Querschnitt mit einem Muster zu versehen;
Projizieren des gemusterten Strahls der Strahlung auf einen Zielabschnitt der Schicht aus dem strahlungsempfindlichen Material;
Bereitstellen eines isolierten Referenzrahmens; und
Lagern des Maskentischs (MT) oder des Substrattischs (WT) mit Lagermitteln, die ein Lagerbauteil aufweisen, das eine begrenzte Steifigkeit in einer senkrechten Richtung hat, die im Wesentlichen senkrecht zu einer Lagerrichtung des Lagerteils ist.

## Revendications

1. Appareil de projection lithographique comprenant :
un système de rayonnement (IL) pour fournir un faisceau de rayonnement de projection ;
une table de masque (MT) pour supporter un masque (MA), le masque (MA) servant mettre en forme le faisceau de rayonnement suivant un motif souhaité ;
une table de substrat (WT) pour maintenir un substrat ;
un système de projection (PL) pour projeter le faisceau mis en forme sur une partie cible du substrat; et
des moyens de support (40) pour supporter la table de masque (MT) ou la table de substrat (WT), les moyens de support (40) comprenant un élément de support (50) ayant une raideur finie dans une direction perpendiculaire qui est sensiblement perpendiculaire à une direction de support de l'élément de support ; et
une chambre à vide (10) ayant une paroi renfermant les moyens de support, les moyens de support comprenant en outre :
une chambre sous pression remplie de gaz (42), le gaz dans la chambre sous pression agissant sur un élément mobile (43) de sorte à compenser au moins partiellement une force sensiblement parallèle à la direction de support, et
des moyens d'évacuation (60a, 60b, 61a, 61b) construits et disposés de manière à évacuer du gaz s'échappant vers la chambre sous pression à travers un intervalle (45) séparant l'élément mobile (43) et une surface portante (41) ; dans lequel
la raideur de l'élément de support (50) est telle qu'une force de déformation dans la direction perpendiculaire de l'élément de support due à une déformation de l'élément de support dans la direction perpendiculaire compense sensiblement une force de déplacement opposée dans la direction perpendiculaire due à une force sensiblement parallèle à la direction de support agissant sur l'élément de support pour permettre le déplacement de la table de masque (MT) ou de la table de substrat (WT) dans la direction perpendiculaire, une force négligeable ou aucune force étant exercée sur la table de masque (MT) ou sur la table de substrat (WT) dans la direction perpendiculaire.

2. Appareil selon la revendication 1, dans lequel l'élément de support comprend une tige (50).

3. Appareil selon la revendication 2, dans lequel la tige (50) comprend une partie rigide (51) et une partie flexible (52).

4. Appareil selon l'une quelconque des revendications précédentes, dans lequel sont prévus des moyens (30) pour appliquer une force supplémentaire à l'élément de support le long de la direction de support.

5. Appareil selon l'une quelconque des revendications précédentes, dans lequel l'élément de support (50) est relié à l'élément mobile (43).

6. Appareil selon l'une quelconque des revendications précédentes, dans lequel les moyens de support (40) comprennent en outre un palier (70, 71) pour supporter l'élément mobile (43) et maintenir l'intervalle (45) entre l'élément mobile et la surface portante (41), le palier comprenant un palier à gaz pour fournir du gaz sous pression à l'intérieur de l'intervalle générant ainsi des forces tendant à maintenir l'élément mobile espacé de la surface portante, les moyens d'évacuation (60a, 60b, 61a, 61b) étant fournis entre le palier à gaz et la chambre à vide le long de l'élément mobile de sorte à retirer du gaz de l'intervalle.

7. Appareil selon la revendication 6, dans lequel le palier à gaz comprend une rainure allongée (70) dans une surface définissant l'intervalle ; et des moyens d'alimentation en gaz (71) pour acheminer du gaz sous pression vers ladite rainure allongée.

8. Appareil selon l'une quelconque des revendications précédentes, dans lequel les moyens d'évacuation comprennent des moyens de conduit (61b) assurant une communication fluidique entre l'intervalle et au moins un réservoir (R) à une pression supérieure à celle de la chambre à vide et inférieure à celle du gaz à retirer de l'intervalle.

9. Appareil selon la revendication 8, dans lequel les moyens de conduit comprennent au moins une rainure allongée (60a, 60b) dans une surface définissant l'intervalle.

10. Appareil selon l'une quelconque des revendications précédentes, dans lequel les moyens d'évacuation comprennent des moyens de conduit supplémentaires (61a) assurant une communication fluidique entre l'intervalle et au moins une pompe à vide.

11. Appareil selon la revendication 10, dans lequel les moyens de conduit supplémentaires comprennent au moins une rainure allongée à vide (60c) dans une surface définissant l'intervalle.

12. Appareil selon la revendication 11, dans lequel les moyens de conduit supplémentaires comprennent plus d'une rainure allongée à vide (60a, 60c) dans une surface définissant l'intervalle, les rainures à vide étant en général parallèles et les rainures respectives vers la chambre à vide étant tirées jusqu'à un vide plus poussé par la/les pompe(s) à vide.

13. Appareil selon l'une quelconque des revendications précédentes, dans lequel l'élément mobile comprend un piston (43) monté en palier dans un boîtier (41) muni de la chambre sous pression remplie de gaz, une paroi interne du boîtier fournissant la surface portante.

14. Appareil selon l'une quelconque des revendications précédentes, dans lequel le système de rayonnement comprend une source de rayonnement (LA).

15. Procédé de fabrication d'un dispositif utilisant un appareil de projection lithographique selon l'une quelconque des revendications précédentes, le procédé comprenant les étapes suivantes :
fournir un substrat qui est au moins partiellement recouvert par une couche de matériau sensible au rayonnement ;
utiliser un masque (MA) pour doter le faisceau de projection d'un motif dans sa section transversale ;
projeter le faisceau de rayonnement mis en forme sur une partie cible de la couche de matériau sensible au rayonnement,
fournir un cadre de référence isolé ; et
supporter l'une de la table de masque (MT) et de la table de substrat (WT) par des moyens de support comprenant un élément de support ayant une raideur finie dans une direction perpendiculaire qui est sensiblement perpendiculaire à une direction de support de l'élément de support.
